# EUROPÄISCHE PATENTANMELDUNG

(11) **EP 0 832 993 A1**
(43) Veröffentlichungstag der Anmeldung: **01.04.1998**
(21) Anmeldenummer: 97116462.9
(22) Anmeldetag: 22.09.1997
(51) Int. Cl.: C23C 28/04, C23C 28/00

(54) **Schichtsystem, Verfahren zur Herstellung desselben und Metallsubstrat mit einem derartigen Schichtsystem**

(30) Priorität: 23.09.1996 DE 19639013
(71) Anmelder: FRAUNHOFER-GESELLSCHAFT ZUR FÖRDERUNG DER ANGEWANDTEN FORSCHUNG E.V., 80636 München (DE)
(72) Erfinder: Dietz, Andreas, Dr., 38304 Wolfenbüttel (DE); Weber, Andreas, Dr., 38104 Braunschweig (DE); Klages, Claus-Peter, Dr., 38102 Braunschweig (DE); von der Heide, Volker, 22455 Hamburg (DE)
(74) Vertreter: Einsel, Martin, Dipl.-Phys.

(57) **Zusammenfassung**

Die Erfindung betrifft ein Schichtsystem zur Beschichtung korrosionsanfälliger Metallsubstrate mit wenigstens einer Zwischenschicht und wenigstens einer Funktionsschicht, wobei die Funktionsschicht ein Nitrid, Carbonitrid und/oder Oxynitrid mindestens eines der Metalle aus der 4. bis 6. Nebengruppe des Periodensystems und die Zwischenschicht aus einem oder mehreren Metalloxiden aufgebaut ist, und ein Verfahren zur Herstellung eines derartigen Schichtsystems, gekennzeichnet durch das Aufbringen einer Metalloxidschicht und das Aufbringen einer Metall-Nitrid-, -Oxynitrid- oder -Carbonitridschicht auf der Metalloxidschicht, wobei beide Schichten mit derelben Beschichtungsprozeßart erzeugt werden.

Bevorzugt wird das Schichtsystem in einem kontinuierlichen Beschichtungsprozeß mittels Hohlkathodengasflußsputtern aufgebaut. Eine korrosionsschützende Zwischenschicht besteht bevorzugt aus elektrisch leitfähigen Metalloxiden, die unter Anlegen einer DC-Biasspannung abgeschieden werden. Das Schichtsystem zeichnet sich durch hohe Verschleißfestigkeit bei gutem Korrosionsschutz aus.

## Beschreibung

Die Erfindung betrifft ein Schichtsystem zur Beschichtung korrosionsanfälliger Metallsubstrate mit wenigstens einer Zwischenschicht und wenigstens einer Funktionsschicht sowie ein Herstellungsverfahren dafür.

Unedle metallische Substrate wie niedriglegierter Stahl, Messing oder Aluminium, die mit Titannitrid mittels DC-Plasma-gestützten PVD-Verfahren (Physical Vapor Deposition) beschichtet werden, sind meist nur unzureichend vor Korrosion geschützt. Die Haupteinsatzzwecke dieser Beschichtungen liegen dabei im dekorativen und tribologischen Bereich. Titannitrid ist elektrisch leitfähig und elektrochemisch sehr edel. Die Schichtstruktur von TiN ist säulenartig, somit ist ein Schutz vor korrosiven Medien nur unzureichend gegeben. Im Gegenteil wird der korrosive Angriff auf das Werkstück aufgrund der elektrochemischen Potentialverhältnisse noch verstärkt, wenn TiN direkt auf das Metall aufgebracht wird. Viele Teile werden deshalb häufig mit einer galvanisch abgeschiedenen Ni-Zwischenschicht versehen, um die Substrate vor einer korrosiven Belastung zu schützen. Dies gilt insbesondere für hochpreisige Gegenstände des täglichen Bedarfs, wie z.B. Kugelschreiber, Armbanduhren oder Schmuck. Seit einiger Zeit ist Nickel im Mittelpunkt einer kritischen Diskussion, da es erwiesenermaßen Allergien auslösen kann. Die Salze gelten als akut toxisch, Ni-Stäube als krebserregend. Deswegen verbietet die Bedarfsgegenständeverordnung ein Freisetzen des Nickels von Gegenständen des täglichen Bedarfs, so daß Hersteller versuchen, den Einsatz von Ni zu minimieren oder es gar zu ersetzen. Da galvanische Beschichtung und die nachfolgende PVD-Beschichtung zwei vollkommen unterschiedliche Verfahren darstellen, deren Arbeitsgänge sich nicht in einer Anlage durchführen lassen, wird ein erheblicher Anteil der Kosten für ein Werkstück durch die Inkompatibilität dieser Prozesse verursacht.

Aus der DE 44 23 184 A1 ist ein mit einem harten Kohlenstoffilm beschichtetes Schneidwerkzeug sowie das Verfahren und eine Vorrichtung zu dessen Herstellung bekannt, bei dem ein metallisches Substrat mit einer hauptsächlich aus Ruthenium zusammengesetzten Zwischenschicht und mit einem auf der Zwischenschicht gebildeten, harten Kohlenstoffilm beschichtet wird. Die Abscheidung der Rutheniumgrundierung erfolgt mittels reaktiver Elektronenstrahlverdampfung, wobei die äußere, diamantähnliche Hartkohlenstoffschicht durch Mikrowellenplasma unterstützte CVD (Chemical Vapor Deposition) abgeschieden wird. Nachteilig ist, daß ein Korrosionsschutz nicht erreicht wird.

Ferner ist aus der US-PS 4, 762, 729 ein Schichtsystem zur Beschichtung von Schneidwerkzeugen bekannt, bei der haftverbessernde Zwischenschichten vorgesehen sind, die von einer im wesentlichen aus kubischem Bornitrid gebildeten Schicht überdeckt werden. Auch hier wird kein besonderer Korrosionsschutz erreicht.

Ferner ist aus der EP 0 093 706 A1 ein Werkzeug und Verfahren zu dessen Herstellung bekannt, bei dem ein Schichtsystem mit einer rein-metallischen Basisbeschichtung, einer gegebenenfalls mehrlagigen Zwischenbeschichtung aus einem hinsichtlich der nicht-metallischen hartstoffbildenden Elemente unterstöchiometrischen, gegebenenfalls etwa 0,2 bis etwa 0,3 Atome Sauerstoff pro Metallatom enthaltenen Nitrid und/oder Carbid mindestens eines der Metalle aus der Gruppe Ti, Zr, Hf, V, Ta und Nb und einer Deckbeschichtung aus einem stöchiometrischen Nitrid, Carbonitrid und/oder Carbid aus der entsprechenden Metallgruppe bevorzugt mit der PVD-Methode aufgebaut wird. Nachteilig ist, daß die aus Nitriden und/oder Carbiden aufgebaute Zwischenschicht aufgrund ihrer Schichtstruktur nur einen unzureichenden Korrosionsschutz für das Substrat bildet, da der Sauerstoffanteil lediglich 0 bis 1 Atomprozent haben soll.

Ferner ist bekannt, daß die meisten Metalloxide, wie z.B. Aluminiumoxid oder Titandioxid nicht leitfähig sind. Diese Eigenschaft macht sie für DC-Sputterverfahren nur sehr begrenzt einsetzbar. Bedingt durch das Beschichtungsverfahren lassen sich diese Schichten nur in sehr geringen Schichtdicken aufbringen. Intrinsisch auftretende Schichtfehler, Staubkörner oder Unregelmäßigkeiten in der Schicht verbieten einen Einsatz dieser Korrosionsschutzschichten. Obschon diese Schichten sehr hart und chemisch relativ inert sind, lassen kleinste Löcher in der Schicht korrosive Medien wie z.B. Schweiß, Seeluft oder industrielle Atmosphäre zum Substrat vordringen. Dort können sie durch Unterwanderung schwere Schäden verursachen. Auch eine nachfolgende Beschichtung mit Titannitrid für dekorative oder tribologische Zwecke kann den Korrosionsschutz nur unwesentlich verbessern, da TiN aufgrund des kolumnaren Wachstums nicht dicht abzuschneiden ist.

Aufgabe der Erfindung ist es daher, ein Schichtsystem bzw. ein Herstellungsverfahren dafür anzugeben, mit dem eine hohe Verschleißfestigkeit und gleichzeitig Korrosionsfestigkeit erreicht wird.

Gelöst wird dies mit einem eingangs genannten Schichtsystem wobei die Funktionsschicht aus einem Nitrid, Carbonitrid und/oder Oxynitrid mindestens eines der Metalle aus der 4. bis 6. Nebengruppe des Periodensystems und die Zwischenschicht aus einem oder mehreren Metalloxiden aufgebaut ist. Verfahrensgemäß wird die Aufgabe gelöst durch das Aufbringen einer Metalloxidschicht und das Aufbringen einer Metall-Nitrid-, -Oxynitrid- oder -Carbonitridschicht auf der Metalloxidschicht, wobei beide Schichten mit derelben Beschichtungsprozeßart erzeugt werden.

Erfindungswesentlich ist dabei, daß unter einer verschleißfesten Funktionsschicht eine aus Metalloxiden aufgebaute Zwischenschicht vorgesehen ist. Die Metalloxidschicht bildet einen hervorragenden Korrosionsschutz. Dabei hat trotz der geringeren Härte der korrosionsschützenden Zwischenschicht das Gesamtsystem eine gute Verschleißfestigkeit.

Bevorzugt besteht die Zwischenschicht aus elektrisch leitfähigen Metalloxiden. Bei derartigen Metalloxiden kann die Beschichtung mittels bekannter Verfahren, wie z.B. das Reaktivgassputtern nach dem Magnetronverfahren oder dem Hohlkathodenverfahren eingesetzt werden. Insbesondere bei PVD-Beschichtungsverfahren nach dem DC-Prinzip ist zum Anlegen einer Biasspannung eine elektrisch leitende Schicht erforderlich, da sich nichtleitende Verbindungen nur in sehr geringen Schichtdicken abscheiden lassen, so daß deren Korrosionsschutz geringer ist.

Als elektrisch leitfähiges Metalloxid eignet sich insbesondere nichtstöchiometrisch zusammengesetztes Oxid mindestens eines der Metalle aus der 4. bis 6.

Nebengruppe des Periodensystems. Mehrere derartige Metallsuboxide zeichnen sich durch eine auch für das DC-Verfahren ausreichende elektrische Leitfähigkeit aus. Diese Metalloxide können somit auch unter Gleichstromvorspannung in der gewünschten Dicke abgeschieden werden.

Alternativ kann auch dotiertes Zinkoxid, Zinnoxid oder Indiumoxid verwendet werden, da durch die Dotierung die gewünschte Leitfähigkeit erzeugt wird.

Daneben können auch einige intrinsisch leitfähige Metalloxide, wie beispielsweise Zinkoxid oder Indium-Zinnoxid (ITO) verwendet werden.

Bevorzugt ist die Funktionsschicht aus Titannitrid und die Zwischenschicht aus nichtstöchiometrisch zusammengesetztem Titanoxid, also aus Titansuboxid, aufgebaut. Das Titansuboxid erzeugt eine leitfähige und korrosionsschützende Zwischenschicht, wobei die elektrische Leitfähigkeit auch für die nachfolgende Beschichtung mit Titannitrid aufgrund der dabei anzulegenden DC-Biasspannung notwendig ist. Das Titannitrid bildet eine verschleißfeste Schicht in ansprechender Farbe, beispielsweise für dekorative Zwecke.

Für das Titansuboxid ist die elektrische Leitfähigkeit am größten, wenn die molekulare Zusammensetzung der allgemeinen Formel Ti_{N}O_{2N-1} mit N = 4 bis 10 entspricht. Diese sogenannten Magneli-Phasen sind als inerte Elektroden in der technischen Elektrochemie bereits bekannt und werden z.B. durch Plasmaspritzen aufgebracht.

Alternativ ist die Funktionsschicht aus Chromnitrid und die Zwischenschicht aus nichtstöchiometrisch zusammengesetztem Chromoxid aufgebaut. Diese Werkstoffpaarung weist ähnliche bevorzugte Merkmale auf.

Um eine ausreichende Korrosionsfestigkeit zu erreichen, weist die Zwischenschicht eine Dicke von 0,1 bis 20 µm auf.

Um eine hohe Verschleiß- und Reibungsfestigkeit zu erhalten, weist die Funktionsschicht eine Dicke von 0,1 bis 20 µm auf.

Zur Verbesserung der Haftung wird zwischen Substrat und Zwischenschicht und/oder zwischen Zwischenschicht und Funktionsschicht eine haftvermittelnde Schicht vorgesehen. Bevorzugt ist dabei die haftvermittelnde Schicht aus mindestens einem der Metalle der 4. bis 6. Nebengruppe des Periodensystems aufgebaut. Die Dicke der haftvermittelnden Schicht sollte dabei ca. 50 nm betragen.

Für die Herstellung des Schichtsystems wird bevorzugt ein PVD-Beschichtungsverfahren angewendet. Von diesen Verfahren ist besonders das Zerstäuben (Sputtern) als Auftragsverfahren geeignet. Das erfindungsgemäß bevorzugteste Verfahren ist das Hohlkathodengasflußsputtern.

Wenn an dem Substrat eine Biasspannung angelegt wird, wird ein besonders hartes und dichtes Schichtsystem aufgebaut. Bevorzugt wird eine Gleichstrom-Biasspannung von -25 bis -500 Volt am Substrat angelegt, da somit eine hohe Dichtigkeit der Beschichtung erreicht wird. Neben dem bevorzugten DC-Verfahren kann jedoch auch eine Wechselspannung angelegt werden. Beispielsweise eignet sich das AC-Verfahren zur Abscheidung von Aluminiumoxid.

Dadurch, daß zum Aufbringen einer Metalloxidschicht wenigstens ein Metall der 4. bis 6. Nebengruppe des Periodensystems und eine unterstöchiometrische Menge Sauerstoff zur Erzeugung einer Metallsuboxidschicht auf dem Substrat zugeführt wird, dann die Sauerstoffzufuhr zurückgenommen wird und Stickstoff zur Erzeugung einer Metall-Nitrid-, -Carbonitrid- oder -Oxynitridschicht auf der Metallsuboxidschicht zugeführt wird, wird das Beschichtungssystem in einem kontinuierlich ablaufenden Beschichtungsprozeß aufgebaut.

Wenn auf dem Substrat zunächst reines Metall abgeschieden wird, wird mit dem kontinuierlich ablaufenden Beschichtungsprozeß eine haftvermittelnde Schicht erzeugt. Eine derartige haftvermittelnde Schicht kann ebenfalls zwischen der Zwischenschicht und der Deckschicht aufgetragen werden. Zur Bildung der Zwischenschicht wird unterstöchiometrisches Metalloxid durch eine begrenzte Sauerstoffzufuhr zur Vakuumbeschichtungskammer mit einer Atmosphäre von Ar/O₂ mit ca. 10 % O₂ erzeugt. Für die nachfolgende Deckschichtbeschichtung wird die Stickstoffzufuhr so eingestellt, daß in der Vakuumkammer eine Atmosphäre von Ar/N₂ mit ca. 50 % N₂ eingestellt wird.

Mit der vorliegenden Erfindung wird ein Schichtsystem, ein Metallsubstrat mit einem derartigen Schichtsystem und ein Herstellungsverfahren dafür angegeben, mit dem eine verschleißfeste und korrosionsschützende Beschichtung insbesondere für dekorative Anwendungsformen erreicht wird. Beispielsweise kann das Schichtsystem auf Uhrarmbändern oder Brillengestellen verwendet werden. Daneben ist natürlich auch die tribologische Anwendung des Schichtsystems möglich, beispielsweise für die Beschichtung von Werkzeugen. Im Gegensatz zu den bisherig bekannten tribologischen Beschichtungen, die vor allem den Verschleißschutz verfolgten, wird mit dem erfindungsgemäßen Schichtsystem darüberhinaus ein guter Korrosionsschutz erreicht. Dabei ist zu berücksichtigen, daß der Schweiß auf der menschlichen Körperoberfläche hochkorrosiv wirkt und wesentlich zu der beschränkten Lebensdauer etwa von Uhrenbändern oder Schmuck beiträgt bzw. deren Dekorationsfunktion rasch sehr abträglich ist.

Nachfolgend werden drei Ausführungsbeispiele der Erfindung erläutert.

### Ausführungsbeispiel 1

Ein Uhrengehäuse plus dazugehörigem Armband aus Messing oder niedriglegiertem Stahl wird in einem Hohlkathodenreaktor mit folgendem Schichtsystem beschichtet:
1. 50 nm metallisches Titan zur Haftungsverbesserung
2. 2 µm Ti_{X}O_{2X-1} als Korrosionsschutzschicht
3. 50 nm metallisches Titan zur Haftungsverbesserung
4. 0,4 µm TiN als verschleißfeste Dekorschicht

Die metallischen Ti-Schichten werden durch Sputtern ohne Biasspannung in einer Inertgasatmosphäre erzeugt. Diese Ti-Schichten werden als Haftvermittler für die nachfolgenden Funktionsschichten eingesetzt. Die Korrosionsschutzschicht aus Titansuboxid wird durch Reaktivsputtern mit einer Biasspannung von 100 V in einer Ar/O₂-Atmosphäre mit 10 % Sauerstoff erzeugt. Die verschleißfeste, dekorativ wirkende Schicht aus TiN wird durch Reaktivsputtern mit einer Biasspannung von 25 V in einer Ar/N₂-Atmosphäre mit 50 % Stickstoff erzeugt. Die Schichten wurden bei einem Gesamtdruck von 0,4 mbar ohne Prozeßunterbrechung hergestellt. Um Adsorptionen von Restgas und Feuchtigkeit auf der Substratoberfläche zu verhindern, wurden die zu beschichtenden Teile mittels einer Heizung auf ca. 200°C aufgeheizt.

### Ausführungsbeispiel 2

Aluminiumschilder im Außenbereich, die für dekorative Zwecke galvanisch vernickelt und vermessingt werden, haben den Nachteil, daß deren Messingoberflächen nach einiger Zeit anlaufen. Das Aluminiumsubstrat korrodiert. Aluminiumschilder, die nach dem im 1. Ausführungsbeispiel beschriebenen Schichtsystem beschichtet sind, bleiben auch im Außenbereich korrosionsfest und dekorativ.

### Ausführungsbeispiel 3

Ein Messingsubstrat wurde mit dem nachfolgenden Schichtsystem beschichtet:
1. 50 nm metallisches Titan zur Haftverbesserung
2. 5 µm Ti₄O₇ als Korrosionsschutzschicht
3. 50 nm metallisches Titan zur Haftverbesserung
4. 0,4 µm Titan-Nitrid als verschleißfeste Deckschicht.

Die Schichten wurden durch Hohlkathodengasstromsputtern nicht reaktiv bzw. reaktiv in Ar/O₂ (10 % O₂) und Ar/N₂ (50 % N₂) bei einem Gesamtdruck von 0,4 mbar ohne Prozeßunterbrechung hergestellt. Zum Vergleich des Korrosionsschutzes mit herkömmlich hergestellten Schichtsystemen mit Nickelschichten wurde das erfindungsgemäße Produkt einem Salzsprühtest nach DIN 50021 und DIN 50980 ausgesetzt. Nach ca. 150 h traten erste Korrosionen auf. Bei dem Vergleichsschichtsystem mit galvanisch abgeschiedener Nickelschicht traten Korrosionserscheinungen nach 160 h auf. Das erfindungsgemäß aufgebaute Schichtsystem erreicht damit fast den gleichen Korrosionsschutz wie das mit der unerwünschten Nickelschicht ausgestattete Schichtsystem.

## Patentansprüche

1. Schichtsystem zur Beschichtung korrosionsanfälliger Metallsubstrate mit wenigstens einer Zwischenschicht und wenigstens einer Funktionsschicht, **dadurch gekennzeichnet**,
**daß** die Funktionsschicht ein Nitrid, Carbonitrid und/oder Oxynitrid mindestens eines der Metalle aus der 4. bis 6. Nebengruppe des Periodensystems und die Zwischenschicht aus einem oder mehreren Metalloxiden aufgebaut ist.

2. Schichtsystem nach Anspruch 1,
**dadurch gekennzeichnet**,
**daß** die Zwischenschicht aus elektrisch leitfähigen Metalloxiden besteht.

3. Schichtsystem nach Anspruch 2,
**dadurch gekennzeichnet**,
**daß** das elektrisch leitfähige Metalloxid ein nichtstöchiometrisch zusammengesetztes Oxid mindestens eines der Metalle aus der 4. bis 6. Nebengruppe des Periodensystems ist.

4. Schichtsystem nach Anspruch 2 oder 3,
**dadurch gekennzeichnet**,
**daß** das Metalloxid dotiertes Zinkoxid, Zinnoxid oder Indiumoxid ist.

5. Schichtsystem nach einem der vorangehenden Ansprüche,
**dadurch gekennzeichnet**,
**daß** die Funktionsschicht aus Titannitrid und die Zwischenschicht aus nichtstöchiometrisch zusammengesetztem Titanoxid aufgebaut ist.

6. Schichtsystem nach Anspruch 5,
**dadurch gekennzeichnet**,
**daß** das Titanoxid ein Titansuboxid der allgemeinen Formel Ti_{N} O_{2N-1} mit N = 4 bis 10, den sogenannten Magneli-Phasen, ist.

7. Schichtsystem nach einem der Ansprüche 1 bis 4,
**dadurch gekennzeichnet**,
**daß** die Funktionsschicht aus Chromnitrid und die Zwischenschicht aus nichtstöchiometrisch zusammengesetztem Chromoxid aufgebaut ist.

8. Schichtsystem nach einem der vorangehenden Ansprüche,
**dadurch gekennzeichnet**,
**daß** die Zwischenschicht eine Dicke von 0,1 bis 20 µm aufweist.

9. Schichtsystem nach einem der vorangehenden Ansprüche,
**dadurch gekennzeichnet**,
**daß** die Funktionsschicht eine Dicke von 0,1 bis 20 µm aufweist.

10. Schichtsystem nach einem der vorangehenden Ansprüche,
**dadurch gekennzeichnet**,
**daß** zwischen Substrat und Zwischenschicht und/oder zwischen Zwischenschicht und Funktionsschicht eine haftvermittelnde Schicht vorgesehen ist.

11. Schichtsystem nach Anspruch 10,
**dadurch gekennzeichnet**,
**daß** die haftvermittelnde Schicht aus mindestens einem der Metalle der 4. bis 6. Nebengruppe des Periodensystems aufgebaut ist.

12. Schichtsystem nach Anspruch 11,
**dadurch gekennzeichnet**,
**daß** die haftvermittelnde Schicht eine Dicke von ca. 50 nm hat.

13. Verfahren zur Herstellung eines Schichtsystems auf korrosionsanfälligen Metallsubstraten gemäß einem der Ansprüche 1 bis 12,
**gekennzeichnet durch**
das Aufbringen einer Metalloxidschicht und das Aufbringen einer Metall-Nitrid-, -Oxynitrid- oder -Carbonitridschicht auf der Metalloxidschicht, wobei beide Schichten mit derselben Beschichtungsprozeßart erzeugt werden.

14. Verfahren nach Anspruch 13,
**dadurch gekennzeichnet**,
**daß** als Beschichtungsprozeß ein PVD-Verfahren angewendet wird.

15. Verfahren nach Anspruch 14,
**dadurch gekennzeichnet**,
**daß** das Schichtsystem mittels Sputtern aufgebaut wird.

16. Verfahren nach Anspruch 15,
**dadurch gekennzeichnet**,
**daß** das Schichtsystem mittels Hohlkathodengasflußsputtern erzeugt wird.

17. Verfahren nach Anspruch 13, 14, 15 oder 16,
**dadurch gekennzeichnet**,
**daß** an dem Substrat eine Biasspannung angelegt wird.

18. Verfahren nach Anspruch 17,
**dadurch gekennzeichnet**,
**daß** als Biasspannung eine Gleichspannung von -25 Volt bis -500 Volt angelegt wird.

19. Verfahren nach einem der Ansprüche 14 bis 18,
**dadurch gekennzeichnet**,
**daß** zum Aufbringen einer Metalloxidschicht wenigstens ein Metall der 4. bis 6. Nebengruppe des Periodensystems und eine unterstöchiometrische Menge Sauerstoff zur Erzeugung einer Metallsuboxidschicht auf dem Substrat zugeführt wird, dann die Sauerstoffzufuhr zurückgenommen wird und Stickstoff zur Erzeugung einer Metall-Nitrid-, - Carbonitrid- oder Oxynitridschicht auf der Metallsuboxidschicht zugeführt wird.

20. Verfahren nach Anspruche 19,
**dadurch gekennzeichnet**,
**daß** auf dem Substrat zunächst reines Metall zur Erzeugung einer haftvermittelnden Schicht aufgetragen wird.

21. Verfahren nach Anspruch 20,
**dadurch gekennzeichnet**,
**daß** nach Zurücknahme der Sauerstoffzufuhr und vor dem Zuführen von Stickstoff reines Metall zur Erzeugung einer haftvermittelten Schicht aufgetragen wird.

22. Verfahren nach einem der Ansprüche 19 bis 21,
**dadurch gekennzeichnet**,
**daß** während der Sauerstoffzufuhr eine Atmosphäre von Ar/O₂ mit ca. 10 % O₂ eingestellt wird.

23. Verfahren nach einem der Ansprüche 19 bis 22,
**dadurch gekennzeichnet**,
**daß** während der Stickstoffzufuhr eine Atmosphäre von Ar/N₂ mit ca. 50 % N₂ eingestellt wird.

24. Metallsubstrat mit einem Schichtsystem nach einem der Ansprüche 1 bis 12.
